Europäisches Patentamt

European Patent Office

Office européen des brevets

(11) Publication number: **0 384 481**
**A1**

(12) **EUROPEAN PATENT APPLICATION**

(21) Application number: **90103553.5**

(22) Date of filing: **23.02.90**

(51) Int. Cl.⁵: **G03F 7/022**

(30) Priority: **23.02.89 JP 43994/89**

(43) Date of publication of application:
**29.08.90 Bulletin 90/35**

(84) Designated Contracting States:
**DE FR GB**

(71) Applicant: **Chisso Corporation**
**6-32, Nakanoshima 3-chome Kita-ku**
**Osaka-shi Osaka-fu(JP)**

(72) Inventor: **Itami, Setsuo**
**17, Tatsumidaihigashi 2-chome**
**Ichihara-shi, Chiba-ken(JP)**
Inventor: **Katou, Kouichi**
**17, Tatsumidaihigashi 2-chome**
**Ichihara-shi, Chiba-ken(JP)**
Inventor: **Maehara, Hiroshi**
**5-23-104, Koukandai 4-chome Kounan-ku**
**Yokohama-shi, Kanagawa-ken(JP)**

(74) Representative: **Hansen, Bernd, Dr.rer.nat. et al**
**Hoffmann, Eitle & Partner Patentanwälte**
**Arabellastrasse 4 Postfach 81 04 20**
**D-8000 München 81(DE)**

(54) **Positive photoresist composition and method for formation of resist pattern.**

(57) The present invention provides a positive photoresist composition which comprises a photosensitive agent (I) comprising an ester of 1,2-naphthoquinonediazide compound with 2,4,4'-trihydroxybenzophenone which has an average esterification degree of 50 mol% or more and an alkali-soluble novolak resin (II) obtained by condensation of a mixture of m-cresol, p-cresol and xylenol with formaldehyde and a process for forming a resist pattern which comprises coating the positive photoresist composition of claim 1 on a substrate, then heat treating the coat, irradiating the coat with radiation and developing the irradiated coat.

# POSITIVE PHOTORESIST COMPOSITION AND METHOD FOR FORMATION OF RESIST PATTERN

## BACKGROUND OF THE INVENTION

### (1) Field of the Invention

The present invention relates to a positive photoresist composition and a method for formation of a resist pattern using this composition. More particularly, it relates to a positive photoresist composition which is markedly superior in resolution and which can provide a good pattern profile perpendicular to a substrate and a method for formation of resist pattern which is suitable for fine pattern formation by lithography, for example, for making semiconductor integrated circuit elements using the above positive photoresist composition.

### (2) Description of Related Art

Quinonediazide compounds have been used as a photosensitive agent in various processes for production of lithographic printing plates or in semiconductor lithography for a long time because these compounds when used in combination with an alkali-soluble resin exhibit an effect to inhibit dissolution of the resin in aqueous alkali solution as a developer and inversely act as an accelerator for dissolution of base polymer in exposed area.

Photosensitive materials prepared by combination of the quinonediazide compounds and alkali-soluble resins are mentioned in detail, for example, in Japanese Patent Post-Examination publication (Kokoku) Nos.37-18015, 37-3627, 37-1954 and 45-9610.

In the photosensitive materials mentioned in the above patent publications, especially 1,2-naphthoquinonediazide-5-sulfonic acid is one of the most widely used photosensitive agents among quinonediazide compounds because this conforms to current semiconductor lithography process in respect of sensitive wavelength or sensitivity. In general, this 1,2-naphthoquinonediazide-5-sulfonic acid is more frequently used in the form of an ester compound with other compounds than used alone. mostly, ester of 1,2-naphthoquinonediazide-5-sulfonic acid with 2,3,4-trihydroxybenzophenone or 2,3,4,4′- tetrahydroxybenzophenone is used in combination with cresol novolak resin.

Since these photosensitive materials have been remarkably improved in resolution of resist and so on, they have been increasingly used, especially, in the field of semiconductor lithography.

In the field of production of semiconductor devices, now is the age of mass-production of 1 Mbit and in the future mass-production of 4 Mbit, furthermore, 16 Mbit will become practical. Accordingly, line width of device pattern becomes finer from 1.0$\mu$ m to 0.8$\mu$ m and further 0.5 $\mu$ m and will finally enter into the halfmicron era.

With the line width of circuit pattern becoming finer in this way, resist used for fine processing of substrate is required to have high resolution of pattern and superiority of pattern profile (cross-section of resist pattern is to be rectangular). Especially when substrate is processed by reactive ion-etching method (RIE), it is especially required that resist pattern be high in resolution and pattern profile be excellent.

However, at present, when positive photoresist formed by using conventional photosensitive agent as mentioned above is used, it is still impossible to realize line width of half-micron with high resolution and resist pattern superior in resist profile.

## SUMMARY OF THE INVENTION

An object of the present invention is to provide a positive photoresist composition which is high in resolution and from which can be obtained a resist pattern having good pattern profile perpendicular to a substrate.

Another object of the present invention is to provide a method for formation of resist pattern using the above positive photoresist composition according to which the substrate can be subjected to fine processing with high accuracy.

As a result of intensive research conducted by the inventors for attaining the above objects, it has been found that a positive photoresist composition comprising a specific quinonediazide ester compound and a specific cresol formaldehyde novolak resin is high in resolution and besides, can be formed into a resist pattern having good pattern profile perpendicular to a substrate and furthermore, by using the resulting resist pattern, fine processing of substrate can be performed with high accuracy and thus, processing to line width of half-micron demanded in the future can be realized. The present invention is based on this findings.

The present invention for attaining the above objects is a positive photoresist composition, which comprises a photosensitive agent (I) comprising an ester of a 1,2-naphthoquinonediazide compound with 2,4,4′-trihydroxybenzophenone which has an average esterification degree of about 50 mol% or more and an alkali-soluble novolak resin (II) obtained by condensation of a mixture of m-cresol, p-cresol and xylenol with formaldehyde, and a method for formation of resist pattern, which comprises coating the above positive photoresist composition on a substrate and then subjecting the composition to heat treatment, irradiation with radiation through photomask and development.

## DESCRIPTION OF THE PREFERRED EMBODIMENT

The present invention will be explained in detail.

### A. Positive photoresist composition

The positive photoresist composition of the present invention comprises a photosensitive agent (I) and an alkali-soluble novolak resin (II).

### Photosensitive agent (I):

Photosensitive agent (I) comprises an ester of a 1,2-naphthoquinonediazide compound with 2,4,4'-trihydroxybenzophenone which has an average esterification degree of about 50 mol% or more.

In the present invention, it is important to use especially an ester of a 1,2-naphthoquinonediazide compound with 2,4,4'-trihydroxybenzophenone among esters of naphthoquinonediazide with hydroxybenzophenones and the objects of the present invention cannot be attained by using an ester of 1,2-naphthoquinonediazide compound with 2,3,4-trihydroxybenzophenone or an ester of 1,2-naphthoquinonediazide-5-sulfonic acid with 2,3,4,4'-tetrahydroxybenzophenone which is most commonly used at present.

The ester of the present invention can be obtained, for example, by reacting 2,4,4'-trihydroxybenzophenone with 1,2-naphthoquinonediazide sulfonyl chloride.

As the 1,2-naphthoquinonediazide sulfonyl chloride, there may be used, for example, 1,2-naphthoquinonediazide-5-sulfonyl chloride and 1,2-naphthoquinonediazide-4-sulfonyl chloride. These may be used singly or as a mixture thereof.

The above reaction results in ester of 1,2-naphthoquinonediazide-4-sulfonic acid with 2,4,4'-trihydroxybenzophenone, ester of 1,2-naphthoquinonediazide-5-sulfonic acid with 2,4,4'-tryhydroxybenzophenone, or mixtures thereof.

In any way, what is important for the present invention is that the ester of 1,2-naphthoquinonediazide compound with 2,4,4'-trihydroxybenzophenone need not be a complete esterification product and average esterification degree thereof may be 50 mol% or more, preferably 60-90 mol%, more preferably 65-85 mol%.

If the average esterification degree is less than 50 mol%, apparent sensitivity is enhanced, but there are problems that not only film retention rate in unexposed area and resolution are deteriorated, but also pattern profile becomes trapezoid and is not perpendicular to substrate. If the average esterification degree is more than 90 mol%, there may occur deterioration in sensitivity, resolution, pattern profile and perpendiculality to substrate and besides, deterioration in storage stability.

This photosensitive agent (I) may comprise only the ester of 1,2-naphthoquinonediazide compound with 2,4,4'-trihydroxybenzophenone or may additionally contain other photosensitive agents as far as attainment of the objects of the present invention is not hindered.

As the other photosensitive agent, mention may be made of, for example, ester of 1,2-naphthoquinonediazide compound with 2,3,4-trihydroxybenzophenone, ester of 1,2-naphthoquinonediazide-5-sulfonic acid with 2,3,4,4'-tetrahydroxybenzophenone, ester of 1,2-naphthoquinonediazide-5-sulfonic acid with 2,3,4,4'-tetrahydroxybenzophenone, ester of 1,2-naphthoquinonediazide-5-sulfonic acid with 2,2',4,4'-tetrahydroxybenzophenone, and ester of 1,2-naphthoquinonediazide-5-sulfonic acid with 2,2',3,4,4'-pentahydroxybenzophenone.

When other photosensitive agent is contained, content of this other photosensitive agent in photosensitive agent (I) is usually about 75% by weight or less, especially about 10-60% by weight.

### Alkali-soluble novolak resin (II):

The alkali-soluble novolak resin as the component (II) has no special limitation and includes any novolak resins which are soluble in aqueous alkali solution, but preferred are condensates of formaldehyde and a mixture of about 40-60% by weight of m-cresol, about 25-45% by weight of p-cresol, about 0-15% by weight of o-cresol and about 10-25% by weight of xylenol, and more preferred are condensates of formaldehyde and a mixture of about 45-55% by weigh of m-cresol, about 30-40% by weight of p-cresol, about 0-5% by weight of o-cresol and about 12-20% by weight of xylenol.

If contents of the respective components are outside the above ranges, the resulting pattern may not be rectangular and not be perpendicular to the substrate when fine pattern is formed.

The suitable component (II) can be obtained, for example, by known process which comprises condensation-reacting a mixture containing m-cresol, p-cresol, o-cresol and xylenol at the above-mentioned ratio with formaldehyde in the presence of a suitable acid catalyst and then heating the reaction mixture under reduced pressure to remove water, monomers and so on.

The acid catalyst used in preparation of component (II) includes, for example, oxalic acid, hydrochloric acid, sulfuric acid, phosphoric acid, p-toluenesulfonic acid, Twitchell reagent, and acid clay.

Molecular weight of the alkali-soluble novolak resin which is the component(II) is usually about 8,000-20,000, preferably about 8,000-15,000 (measured by gel permeation chromatography using polystyrene as a standard material).

If this weight-average molecular weight is less than about 8,000, solubility of the composition in developing solution increases to cause increase in reduction of film of unexposed area and besides, shape of cross-section of the resulting resist pattern may lose rectangularity and become trapezoid. On the other hand, when weight-average molecular weight exceeds about 20,000, much reduction of sensitivity, deterioration of resolution or decrease of dimensional accuracy in processing of substrate at etching step may be brought about. In addition, influence of standing wave increases and this also reduces dimensional accuracy in processing of substrate.

Mixing ratio of respective components:

Mixing ratio of component (I) and component (II) in the positive photoresist composition of the present invention is about 20-30 parts by weight, preferably about 22-27 parts by weight of the photosensitive agent which is component (I) per 100 parts by weight of the alkali-soluble novolak resin which is component (II).

If addition amount of component (I) to component (II) is less than about 20 parts by weight, the effect of preventing dissolution exhibited by component (I) may decrease to cause deterioration in quality of pattern afforded by the photoresist composition of the present invention and superior resist pattern having perpendicularity to substrate may become difficult to obtain. If it is more than about 30 parts by weight, there may occur reduction of apparent sensitivity, trapezoid cross-section of the resulting resist pattern or reduction in dimensional accuracy in processing of substrate at etching step. Moreover, influence of standing wave increases and this may also reduce dimensional accuracy in processing of substrate.

Other components:

The positive photoresist composition may contain, in addition to the components (I) and (II), other components such as sensitizer, dye, plasticizer, stabilizer and adhesion accelerator.

However, in that case, addition amount of these other components must be properly set so that rectangularity of cross-section and perpendicularity of the resulting resist pattern to the substrate are not damaged.

The sensitizer can be selected depending on the kind of radiation used for formation of photoresist. For example, when visible light is used as radiation, there may be used pyrene, 2H-pyrido-[3,2-b]-1,4-oxazine-3[4H]ones, 10H-pyrido[3,2-b]-[1,4]-benzothiazines, uranols, 1-hydroxybenzotriazoles, hydantoins, barbiturs, glycine anhydride, alloxans, maleimides and the like.

As the dyes, mention may be made of, for example, oil-soluble dyes, disperse dyes, basic dyes, methine dyes, fluorescent brightening agents such as stilbene, 4,4-diaminostilbenesulfonic acid derivatives, coumalin derivatives, and pyrazolone derivatives and azo dyes.

The plasticizers include, for example, stearic acid, acetal resin, alkyd resin and phenoxy resin.

The stabilizers include, for example, phenols such as p-methoxyphenol and p-methoxy-t-butylphenol.

The adhesion accelerators include, for example, silicone compounds such as 3-aminopropyltriethoxysilane, hexamethyldisilazane, chloromethylsilane, and trimethoxysilane.

The positive photoresist composition of the present invention can be obtained by blending the above-mentioned components.

B. Formation of resist pattern:

In order to form the resist pattern of the present invention, in general, firstly a coating solution obtained by dissolving the positive photoresist composition in a suitable solvent is coated on a substrate.

As the solvent, mention may be made of, for example, ketones such as methyl ethyl ketone; chlorinated hydrocarbons such as trichloroethylene and 1,1,1-trichloroethane; alcohols such as n-propanol; ethers such as tetrahydrofuran; alcohol ethers such as ethylene glycol monoethyl ether; alcohol ether acetates such as ethylene glycol monoethyl ether acetate and propylene glycol monoethyl ether acetate; and esters such as butyl acetate. Furthermore, for example, acetonitrile, xylene and dimethylformamide can also be used for some purposes.

As the substrate, for example, silicon wafer can be used.

Coating of the coating solution on the substrate can be carried out, for example, by spinner coating method and bar coater method.

After coating the coating solution, solvent is removed by heat treating to form a photosensitive agent layer on the surface of the substrate.

Conditions of the heat treatment are as follows: Heating temperature is usually about 80 120- °C, preferably about 100- 110 °C and heating time is usually about 0.5- 3 minutes, preferably about 1.5- 2 minutes.

Then, the photosensitive agent layer is exposed to radiation through a given photomask using, for example, a reduction type projection exposing apparatus.

The radiation includes, for example, visible light, ultraviolet rays, far ultraviolet rays, X-rays, gamma-ray, electron rays, molecular beam, synchrotron radiation, and proton beam. Among them, preferred are visible light and ultraviolet-rays. The energy of the radiation is usually about $1 \times 10^2$ - $3 \times 10^2$ mJ/cm$^2$, preferably about $1.8 \times 10^2$ -$2.2 \times 10^2$ mJ/cm$^2$. Thereafter, when development is carried out with a suitable developer, the portion solubilized by the exposure is selectively dissolved and removed to obtain a resist pattern faithful to mask pattern.

As the developer, there may be suitably used quaternary ammonium hydroxide such as tetramethylammonium hydroxide, aqueous solutions of alkali metal such as sodium hydroxide and potassium hydroxide and these developers to which alcohol, surface active agent or the like is added depending on purpose. Especially preferred is aqueous solution of tetramethylammonium hydroxide.

By using the positive type photoresist composition of the present invention, not only markedly excellent resolution can be obtained, but also there can be formed a resist pattern having superior profile having good perpendicularity to a substrate in fine pattern which has been difficult to obtain using conventional single resist layer.

Therefore, the resulting resist pattern is suitable as resist pattern for fine processing of substrate. For example, the resist pattern can be favorably utilized in the field of production of semiconductor integrated circuit devices such as ultra LSI and IC or production of photomask and besides, it is useful in the field of offset printing.

The present invention will be explained in more detail by the following nonlimiting examples and comparative examples, wherein "%" means "% by weight" unless otherwise notified.

Example 1

Ester of 1,2-naphthoquinonediazide-5-sulfonic acid with 2,4,4'-trihydroxybenzophenone (average esterification degree: 75 mol%) and cresol novolak resin [molecular weight: 12,500; prepared from formaldehyde and a mixture comprising 53.4% of m-cresol, 28.8% of p-cresol, 0.6% of o-cresol, 2.3% of 2,6-xylenol, and 14.6% of a mixture of 2,4-xylenol and 2,5-xylenol] were mixed at a weight ratio (photosensitive agent) : (alkali-soluble cresol novolak resin) of 25:75. This mixture was dissolved in an amount of 39% by weight in ethylcellosolve acetate to obtain a solution of a positive photoresist composition of the present invention.

Then, the resulting solution was filtrated by Teflon membrane filter (0.2μ m) and spin-coated on a 4 inch silicon wafer by a spin coater and the coat was heat treated at 105 °C for 2 minutes by a hot plate.

Thereafter, the coat was exposed to the light of 436 nm through a test reticle using a reduction type projection exposing apparatus (NSR-1505G, wafer stepper, NA-0.30).

The exposed coat was developed with 2.38% aqueous tetramethylammonium hydroxide solution for 1 minute and then rinsed for 1 minute with deionized water to obtain a resist pattern.

Shape of cross-section of the resulting resist pattern was photographed from the direct front side of the cross-section using a scanning electron microscope (SEM).

The SEM photograph showed that the resist pattern was perpendicular to the substrate and had a good pattern profile.

Resolution of the resist was examined to find that line and space pattern of 0.85 μ m was excellently resolved and reproducibility to mask pattern was also excellent up to 0.90μ m.

Furthermore, the resist pattern obtained in this example was observed by a scanning electron microscope at a low accelerating voltage from above the resist to detect no residue of resist (scum).

Example 2

A mixed photosensitive agent for positive photoresist composition was prepared by mixing ester of 1,2-naphthoquinonediazide-5-sulfonic acid with 2,4,4'-trihydroxybenzophenone (average esterification degree: 66.7 mol%) and ester of 1,2-naphthoquinonediazide-5-sulfonic acid with 2,3,4,4'-tetrahydroxybenzophenone (average esterification degree: 75 mol%) at a weight ratio of the former : the latter of 50:50.

Then, the resulting photosensitive agent was mixed with cresol novolak resin [molecular weight: 10,500; prepared from formaldehyde and a mixture comprising 48.4% of m-cresol, 36.9% of p-cresol, 0.4% of o-cresol, 2.0% of 2,6-xylenol and 12.6% of a mixture of 2,4-xylenol and 2,5-xylenol] at a weight ratio of (photosensitive agent) : (cresol novolak resin) of 20:80. This mixture was dissolved in an amount of 39% by weight in ethylcellosolve acetate to obtain a solution of a positive photoresist composition of the present invention.

Then, the resulting solution was filtrated by a Teflon membrane filter (0.2μ m) and was spin-coated on a 4 inch silicon wafer by a spin coater and thereafter, the coat was heat treated by a hot plate of 105° C for 2 minutes.

Then, the coat was exposed through a test rectile by a reduction type projection exposing apparatus (NSR-1505G, wafer stepper, NA = 0.30).

This was developed with 2.38% aqueous tetramethylammonium hydroxide solution for 1 minute and thereafter, was rinsed with deionized water for 1 minute to form a resist pattern.

Shape of cross-section of the resulting resist pattern was photographed from the direct front side of the cross-section using a scanning electron microscope (SEM).

The SEM photograph showed that the resist pattern was perpendicular to the substrate and had a good pattern profile.

Resolution of the resist was examined to find that line and space pattern of 0.80 μ m was excellently resolved and reproducibility to mask pattern was also excellent up to 0.85μ m.

The resist pattern obtained in this example was observed by a scanning electron microscope at a low accelerating voltage from above the resist to detect no residue of resist (scum).


Example 3

Example 2 was repeated except that ester of 1,2-naphthoquinonediazide-5-sulfonic acid with 2,4,4′-trihydroxybenzophenone which had an average esterification degree of 75 mol% was used in place of the ester of 1,2-naphthoquinonediazide-5-sulfonic acid with 2,4,4′-trihydroxybenzophenone which had an average esterification degree of 66.7 mol%.

Shape of cross-section of the obtained resist pattern was photographed from the direct front of the pattern cross-section by a scanning electron microscope (SEM) as in Example 2.

The SEM photograph showed that the resist pattern was perpendicular to the substrate and very good pattern profile was obtained.

Resolution of the resist was examined to find that line and space pattern of 0.75 μ m was satisfactorily resolved and reproducibility to mask pattern was excellent up to 0.80μ m.

The resist pattern obtained in this example was observed from above the pattern by a scanning electron microscope at a low accelerating voltage to detect no residue of resist (scum).


Example 4

Example 2 was repeated except that ester of 1,2-naphthoquinonediazide-5-sulfonic acid with 2,4,4′-trihydroxybenzophenone which had an average esterification degree of 83.3 mol% was used in place of ester of 1,2-naphthoquinonediazide-5-sulfonic acid with 2,4,4′-trihydroxybenzophenone which had an average esterification degree of 66.7 mol%.

Shape of cross-section of the obtained resist pattern was photographed from the direct front of the pattern cross-section by a scanning electron microscope (SEM) as in Example 2.

The SEM photograph showed that the resist pattern was perpendicular to the substrate and very good pattern profile was obtained.

Resolution of the resist was examined to find that line and space pattern of 0.75 μ m was satisfactorily resolved and reproducibility to mask pattern was excellent up to 0.80μ m.

The resist pattern obtained in this example was observed from above the pattern by a scanning electron microscope at a low accelerating voltage to detect no residue of resist (scum).


Example 5

Using the same solution of positive photoresist as of Example 3, filtration and spin-coating were carried out in the same manner as in Example 3 and then, the coat was heat treated on a hot plate of 80° C for 90 seconds.

Thereafter, the coat was exposed through a test reticle by a reduction type projection exposing apparatus (NSR-1505G4D, wafer stepper, NA = 0.45) and heat treated on a hot plate of 100° C for 90 seconds.

This was developed and rinsed in the same manner as in Example 3 to form a resist pattern.

Shape of cross-section of the resulting resist pattern was photographed from the direct front of the cross-section by a scanning electron microscope (SEM) as in Example 3.

The SEM photograph showed that the resist pattern was perpendicular to the substrate and excellent pattern profile was realized.

Resolution of the resist was examined to find that it resolved satisfactorily the line and space pattern of 0.50μ m and reproducibility to mask pattern was good up to 0.52μ m.

Furthermore, the resist pattern obtained in this example was observed from above by a scanning electron microscope at a low accelerating voltage to detect no residue of resist (scum).

Comparative Example 1

Treatment and evaluation were carried out in the same manner as in Example 1 except that ester of 1,2-naphthoquinonediazide-5-sulfonic acid with 2,3,4-trihydroxybenzophenone which had an average esterification degree of 75 mol% was used in place of ester of 1,2-naphthoquinonediazide-5-sulfonic acid with 2,4,4'-trihydroxybenzophenone which had an average esterification degree of 75 mol%.

Shape of cross-section of the resulting resist pattern was photographed from the direct front of the cross-section by a scanning electron microscope (SEM) as in Example 1.

The SEM photograph showed that the resist pattern profile was extremely inferior to that obtained in Example 1 and edge of the resist pattern was roundish.

Comparative Example 2

Treatment and evaluation was carried out in the same manner as in Example 3 except that ester of 1,2-naphthoquinonediazide-5-sulfonic acid with 2,3,4-trihydroxybenzophenone which had an average esterification degree of 75 mol% was used in place of ester of 1,2-naphthoquinonediazide-5-sulfonic acid with 2,4,4'-trihydroxybenzophenone which had an average esterification degree of 75 mol%.

Shape of cross-section of the resulting resist pattern was photographed from the direct front of the cross-section by a scanning electron microscope (SEM) as in Example 3.

The SEM photograph showed that the resist pattern profile was extremely inferior to that obtained in Example 3 and edge of the resist pattern was roundish and besides, resolution was inferior, namely, at most 0.80 $\mu$ m.

Comparative Example 3

Treatment and evaluation was carried out in the same manner as in Example 5 except that ester of 1,2-naphthoquinonediazide-5-sulfonic acid with 2,3,4-trihydroxybenzophenone which had an average esterification degree of 75 mol% was used in place of ester of 1,2-naphthoquinonediazide-5-sulfonic acid with 2,4,4'-trihydroxybenzophenone which had an average esterification degree of 75 mol%.

Shape of cross-section of the resulting resist pattern was photographed from the direct front of the cross-section by a scanning elecron microscope (SEM) as in Example 5.

The SEM photograph showed that the resist pattern profile was extremely inferior to that obtained in Example 5 and edge of the resist pattern was roundish. Further, resolution was also inferior, namely, 0.55$\mu$ m and reproducibility to mask pattern was also inferior, namely, at most 0.60 $\mu$ m.

As explained above, the positive photoresist pattern of the present invention can give excellent resist pattern profile and besides, is excellent in resolution.

Therefore, a resist pattern by which fine processing of the order of micron can be performed for a substrate by using the positive photoresist composition of the present invention.

Claims

1. A positive photoresist composition which comprises a photosensitive agent (I) comprising an ester of a 1,2-naphthoquinonediazide compound with 2,4,4'-trihydroxybenzophenone which has an average esterification degree of 50 mol% or more and an alkali-soluble novolak resin (II) obtained by condensation of a mixture of cresol and xylenol with formaldehyde.

2. A composition according to claim 1, wherein the ester of 1,2-naphthoquinonediazide compund with 2,4,4'-trihydroxybenzophenone is ester of 1,2-naphthoquinonediazide-4-sulfonic acid with 2,4,4'-trihydroxybenzophenone, ester of 1,2-naphthoquinonediazide-5-sulfonic acid with 2,4,4'-trihydroxybenzophenone or a mixture thereof.

3. A composition according to claim 1, wherein the average esterification degree of the ester is 50-90 mol%.

4. A composition according to claim 1, wherein the average esterification degree of the ester is 65-85 mol%.

5. A composition according to claim 1, wherein the mixture of cresol and xylenol comprises 40-60% by weight of m-cresol, 25-45% by weight of p-cresol, 0-15% by weight of o-cresol, and 10-25% by weight of xylenol.

6. A composition according to claim 1, wherein the alkali-soluble novolak resin (II) has a molecular weight of 8,000-20,000.

7. A composition according to claim 1, wherein content of the photosensitive agent (I) is 20-30 parts by weight per 100 parts by weight of the alkali-soluble novolak resin (II).

8. In a process for forming a resist pattern, the improvement comprising coating the positive photoresist composition of claim 1 on a substrate and then subjecting the coat to heat treatment, irradiation with radiation and development.

9. In a process for forming a resist pattern on a silicon wafer, the improvement comprising coating the positive photoresist composition of claim 1 on the silicon wafer and then subjecting the coat to heat treatment, irradiating with radiation and development.

10. A process according to claim 8, wherein the heat treatment is carried out by heating at 80-120 °C for 0.5-3 minutes.

European Patent Office

# EUROPEAN SEARCH REPORT

Application Number

EP 90 10 3553

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | CHEMICAL ABSTRACTS, vol. 97, no. 8, 23 August 1982 Columbus, Ohio, USA page 558; ref. no. 64162Q & SU-A-913320(Timerova N.D. et al.)(15.03.1982) * abstract * | 1-7 | G03F7/022 |
| Y | DE-A-3603372 (MITSUBISHI CHEM IND LTD) * claims 1-5 * | 1-7 | |
| X | *Example 3, Table 1* | 8-10 | |
| A | SOLID STATE TECHNOLOGY. vol. 27, no. 6, June 1984, WASHINGTON US pages 115 - 120; T.R. Pampalone: "Novolac Resins Used in Positive Resist Systems" * page 115, right-hand column, last paragraph * | 1-7 | |
| A | CHEMICAL ABSTRACTS, vol. 94, no. 12, 23 March 1981 Columbus, Ohio, USA page 665; ref. no. 93699P & SU-A-781145(Balashova N.G.et al.)(23.11.1980) * abstract * | 1-7 | TECHNICAL FIELDS SEARCHED (Int. Cl.5) G03F7/00 |

The present search report has been drawn up for all claims

| Place of search | Date of completion of the search | Examiner |
|---|---|---|
| THE HAGUE | 07 JUNE 1990 | LUDI M.M.B. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)